# EUROPÄISCHE PATENTSCHRIFT

(11) **EP 1 854 168 B1**
(45) Veröffentlichungstag und Bekanntmachung des Hinweises auf die Patenterteilung: **16.05.2012**
(21) Anmeldenummer: 06706322.2
(22) Anmeldetag: 20.01.2006
(51) Int. Cl.: H01Q 1/12, H01Q 1/38, H05K 1/00, H01Q 1/32

(54) **FOLIENANTENNE FÜR EIN FAHRZEUG**
FILM ANTENNA FOR A MOTOR VEHICLE
ANTENNE EN FEUILLE POUR UN VEHICULE

(30) Priorität: 02.03.2005 DE 102005009443
(43) Veröffentlichungstag der Anmeldung: 14.11.2007
(73) Patentinhaber: Hirschmann Car Communication GmbH, 72654 Neckartenzlingen (DE)
(72) Erfinder: SCHWARZ, Bernd, 72141 Walddorf-Häslach (DE); PFLETSCHINGER, Markus, 72800 Eningen (DE)
(74) Vertreter: Greif, Thomas
(86) Internationale Anmeldenummer: PCT/EP2006/000481
(87) Internationale Veröffentlichungsnummer: WO 2006/092188

(56) Entgegenhaltungen:
- EP-A- 0 262 755
- DE-A1- 10 242 526
- US-A- 4 873 532
- US-A- 5 712 645
- US-A1- 2004 263 405
- US-B1- 6 204 480
- TROGISCH G: "FLEXIBLE LEITERPLATTEN IM AUFWIND" FEINWERKTECHNIK + MESSTECHNIK, HANSER, MUNCHEN., DE, Bd. 97, Nr. 11, 1. November 1989 (1989-11-01), Seiten 485-488, XP000072699 ISSN: 0340-1952

## Beschreibung

### Technisches Gebiet

Die Erfindung betrifft eine Antennenanordnung für ein Fahrzeug mit zumindest einer leitfähigen Antennenstruktur gemäß den Merkmalen des Oberbegriffes des Patentanspruches 1.

### Stand der Technik

Aus der DE 198 23 202 ist eine Antennenanordnung für ein Fahrzeug bekannt, die zumindest eine leitfähige Antennenstruktur aufweist, wobei diese leitfähige Antennenstruktur in Form eines elektrischen Leiters in oder auf einem flächigen Bauteil des Fahrzeuges angeordnet ist. Bei diesem Stand der Technik ist das flächige Bauteil des Fahrzeuges eine Fensterscheibe, insbesondere die Heckscheibe. Die Antennenstrukturen sind elektrisch mit einem Antennenverstärker kontaktiert, wobei der Antennenverstärker eine Leiterplatte mit Leiterbahnen aufweist, auf der die entsprechenden Bauteile angeordnet und mit den Leiterbahnen kontaktiert sind, um die Funktion des Antennenverstärkers zu realisieren. Die Leiterplatte selber wird in einen Kunststoffrahmen eingesetzt, nachdem der Kunststoffrahmen seinerseits auf der Heckscheibe durch einen Klebevorgang fixiert worden ist. Zur Kontaktierung der Antennenstrukturen mit dem Antennenverstärker sind die Antennenstrukturen zu bestimmten Kontaktstellen geführt, die ebenfalls auf der Heckscheibe angeordnet werden müssen. Beim Einsetzen der Leiterplatte in den Kunststoffrahmen erfolge eine elektrische Verbindung zwischen den Kontaktstellen der Antennenstruktur und den korrespondierenden Kontaktstellen auf der Leiterplatte durch zwischengeschaltete Kontaktfedern. Eine solche bekannte Antennenanordnung hat sich zwar vielfach in der Praxis bewährt, ist aber hinsichtlich der Flexibilität (z.B. wenn sich Antennenstrukturen ändern) sowie auf Grund des hohen Montageaufwandes unbefriedigend. Darüber hinaus ist die Kontaktierung zwischen der Kontaktstelle der Antennenstruktur und der korrespondierenden Kontaktstelle auf der Leiterplatte möglich. Außerdem ist es für den Fall, dass eine Antennenstruktur beschädigt wurde, immer zwangsweise erforderlich, dass die gesamte Scheibe ausgetauscht werden muss, was in nachteiliger Weise mit hohen Kosten verbunden ist.

### Darstellung der Erfindung

Der Erfindung liegt daher die Aufgabe zu Grunde, eine Antennenanordnung für ein Fahrzeug mit einem nachgeschalteten elektronischen Gerät bereitzustellen, das hinsichtlich der Flexibilität sowie der Kontaktsicherheit verbessert ist und darüber hinaus der Montageaufwand verringert wird.

Diese Aufgabe ist durch die Merkmale des Patentanspruches 1 gelöst.

Erfindungsgemäß ist vorgesehen, dass die zumindest eine Antennenstruktur in oder auf einer Folie angeordnet ist, wobei die Folie einen Kontaktbereich aufweist, über den die zumindest eine Antennenstruktur direkt oder über zumindest einen Kontaktpartner mit dem elektronischen Gerät elektronisch verbunden ist und die Folie an dem flächigen Bauteil angeordnet wird. Die Kombination dieser Merkmale hat mehrere Vorteile. Zum einen ist eine sehr hohe Flexibilität gegeben, da ein aufwändiger Herstellungsprozess eines flächigen Bauteiles des Fahrzeuges mit darin integrierten Antennenstrukturen entfallen kann. Denn in vorteilhafter Weise sind die Antennenstrukturen nunmehr in oder auf der Folie vorhanden und dort beispielsweise als eine elektrisch leitfähige Paste aufgebracht. Die Antennenstrukturen können beispielsweise in einem Siebdruckverfahren in einfachster Weise auf die Folie gedruckt werden. Damit lassen sich Änderungen der Antennenstrukturen sehr schnell und auf einfache Art und Weise realisieren, ohne dass der Herstellungsprozess des flächigen Bauteiles berücksichtigt werden muss. Denn gerade bei Scheiben von Fahrzeugen, die Regelfall aus Verbundmaterial bestehen, sind aufwändige Abstimmungsprozesse erforderlich, wenn innerhalb dieses Verbundes Antennenstrukturen vorhanden sind und diese geändert werden müssen. Außerdem wird der Montageaufwand deutlich verringert, da eine Folie auf die entsprechenden Maße des flächigen Bauteiles zugeschnitten werden kann, und anschließend mit dem flächigen Bauteil durch entsprechende Maßnahmen verbunden wird. Solche Maßnahmen können z.B. Clipsvorgänge, Klebungen oder dergleichen sein.

Die Montage der Folie in bzw. auf das flächige Bauteil kann zum Beispiel mit Hilfe von Clipsen oder Kleben erfolgen. Klemmen oder Fixieren der Folie mit Hilfe eines Halterahmens ist auch möglich. Das Einlegen zwischen zwei Schichten eines Kunststoffteils stellt eine besonders elegante Lösung dar. Die Strukturen der Antenne sind dann besonders gut geschützt und die Folie ist gleichzeitig fixiert.

Nachdem die Folie an dem flächigen Bauteil angeordnet worden ist, erfolgt ebenfalls sie Anordnung des elektronischen Gerätes benachbart zu der Folie, die ihrerseits am Ende der jeweiligen Antennenstrukturen einen Kontaktbereich aufweist, an dem die Enden der Antennenstrukturen zusammenlaufen zwecks Kontaktierung. Dieser Kontaktbereich wird entweder direkt mit dem elektronischen Gerät verbunden, oder es sind Zwischenschaltungen von elektrischen Leitern möglich. Die Zwischenschaltung von elektrischen Leitern kommt dann in Betracht, wenn die Folie mit den Antennenstrukturen entfernt von dem Ort angeordnet ist, an dem sich das elektronische Gerät befindet. Sind aber Kontaktbereich der Folie und elektronisches Gerät benachbart zueinander angeordnet, bietet es sich an, den Kontaktbereich, d.h. den Endbereich der elektrisch leitfähigen Antennenstrukturen, direkt mit korrespondierenden Kontaktpartnern bzw. Kontaktstellen des elektronischen Gerätes elektrisch zu verbinden. So kann beispielsweise daran gedacht werden, dass die auf der Folie freiliegenden elektrisch leitfähigen Enden der Antennenstruktur mittels eines elektrisch leitfähigen Klebers mit korrespondierenden Leiterbahnen auf der Leiterplatte des elektronischen Gerätes verbunden werden. Unter einer direkten Verbindung sind also solche Vorgänge (lösbare oder unlösbare Verbindungsvorgänge) zu verstehen, bei denen die Enden der Antennenstrukturen direkt elektrisch mit den korrespondierenden Kontaktstellen auf der Leiterplatte des elektronischen Gerätes verbunden werden. Alternativ dazu kann daran gedacht werden, eine Art indirekte elektrische Verbindung vorzunehmen, wozu z.B. im Kontaktbereich der Folie eine Steckverbindung vorgesehen wird, die in eine korrespondierende Steckverbindung an dem elektronischen Gerät eingesteckt wird. Darüber hinaus ist es weiterhin denkbar, dass im Kontaktbereich der Folie ein Steckverbinder mit Kontaktpartnern vorhanden ist, wobei die Anzahl der Kontaktpartner dieses Steckverbinders der Anzahl der Antennenstrukturen entspricht. Es ist auch denkbar, mehrere Antennenstrukturen zu mehreren Steckverbindern zu führen, so dass für verschiedene Antennenstrukturen auch verschiedene Steckverbinder realisiert sind. Der zumindest eine Steckverbinder oder auch mehrere Steckverbinder können dann mit korrespondierenden Steckverbindern an dem elektronischen Gerät kontaktiert werden oder für den Fall, dass das elektronische Gerät nicht benachbart zu der Folie mit den Antennenstrukturen angeordnet ist, über zwischengeschaltete elektrische Leiter (also eine Art Verlängerungskabel) elektrisch verbunden werden.

Je nach Anwendungsfall kommen zur Verbindung der Kontaktpartner der Antennenstruktur mit den korrespondierenden Kontaktstellten bzw. Kontaktpartnem des elektronischen Gerätes lösbare Verbindungen wie Schraub- oder Steckverbindungen in Betracht. Diese haben den Vorteil, dass die Folie mit der Antennenstruktur bzw. das elektronische Gerät z.B. im Defektfalle voneinander getrennt und ausgetauscht werden können. Ergänzend oder alternativ dazu kommen unlösbare elektrische Verbindungen wie z.B. Crimp-, Löt-, Klebe-, Niet- oder Bondverbindungen (Bonden = Verbinden durch Klebung und Erwärmung) in Betracht.

In einer besonderen Ausgestaltung der Erfindung sind Leiterbahnen und mit diesen Leiterbahnen kontaktierte Bauelemente zur Realisierung der Funktion des elektronischen Gerätes ebenfalls in Ergänzung zu den Antennenstrukturen auf der Folie angeordnet. Dies hat den besonderen Vorteil, dass sowohl die Leiterbahnen des elektronischen Gerätes als auch die Antennenstrukturen auf oder in der Folie angeordnet sind. Besonders vorteilhaft ist die Anordnung der elektrisch leitfähigen Bereiche auf der Folie, so dass diese z.B. in einem Siebdruckverfahren auf die Folie aufgedruckt werden können. Insgesamt steht nach Bestückung der Leiterbahnen mit den entsprechenden Bauelementen zur Realisierung der Funktion des elektronischen Gerätes eine vorfertigbare Folie zur Verfügung, die geprüft und nach erfolgreicher Prüfung an den Fahrzeughersteller zum Einbau in das Fahrzeug geliefert werden kann. Es ist lediglich noch eine Stromversorgung und eine ausgangsseitige Kontaktierung des elektronischen Gerätes mit nachgeschalteten Geräten erforderlich. Eine weitere Kontaktierung zwischen den Antennenstrukturen und dem elektronischen Gerät kann damit entfallen, was bedeutet, dass die zumindest eine Antennenstruktur direkt mit dem elektronischen Gerät verbunden ist. Somit werden jegliche Kontaktprobleme zwischen der zumindest einen Antennenstruktur und dem elektronischen Gerät vermieden. Darüber hinaus reduziert sich in vorteilhafter Weise die Bauteilvielfalt, so dass Kosteneinsparungen möglich sind.

Wenn somit das erfindungsgemäße Gesamtkonzept (Montage sowie Integration) betrachtet wird, sind in vorteilhafter Weise Kosteneinsparungen zu erwarten.

Da in Fahrzeugen in Zukunft vermehrt Kunststoffteile eingesetzt werden, bieten diese die Möglichkeit mit hoher Designfreiheit dort Antennen bzw. Antennenstrukturen auf der Folie zu integrieren, so dass eine Anpassung an die neuen Möglichkeiten ohne weiteres gegeben ist.

### Kurze Beschreibung der Zeichnung

Verschiedene Beispiele und Ausführungsbeispiele der Erfindung, auf die diese jedoch nicht beschränkt ist, sind im Folgenden beschrieben und anhand der Figuren erläutert.

Es zeigen:
- Figur 1:: eine Folie mit Antennenstrukturen,
- Figur 2:: verschiedene Kontaktpartner, die an der Folie angeordnet sind,

- Figur 3:: ein Steckverbinder, der an der Folie angeordnet ist,
- Figur 4:: ein elektronisches Gerät, das an der Folie mit Antennenstrukturen angeordnet ist,
- Figur 5:: ein elektronisches Gerät, das auf der Folie angeordnet ist

### Beispiele und Wege zur Ausführung der Erfindung

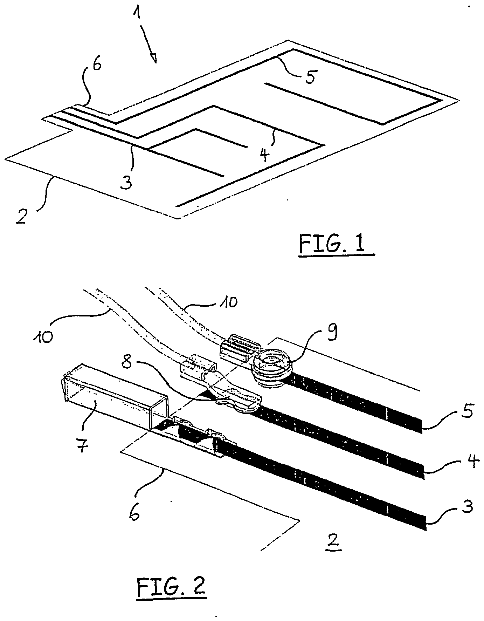

Figur 1 zeigt als Beispiel eine Atennenanordnung 1, bei der auf einer Folie 2 mehrere Antennenstrukturen 3, 4, 5 vorhanden sind. Diese Antennenstrukturen 3 bis 5 sind z.B. in einem Siebdruckverfahren oder mittels jedes anderen geeigneten Verfahrens auf der Folie 2 aufgebracht, wobei sich die geometrische Form und Erstreckung der Antennenstrukturen 3 bis 5 auf der Folie 2 nach den zu empfangenden bzw. auszusendenden Frequenzen richten. Die gezeigten Antennenstrukturen 3 bis 5 sind beispielhaft und werden auf die jeweiligen Anwendungsfälle abgestimmt. Anwendungsfälle sind beispielsweise der Empfang von Radiosignalen (AM, FM, DAB oder dergleichen), Fernsehsignalen (TV, DVB-T oder dergleichen) oder sonstiger Signale (z.B. für Zentralverriegelungen von Fahrzeugen oder dergleichen). Die Folie 2 entspricht mit ihren Abmessungen höchstens den Ausmaßen des flächigen Bauteils des Fahrzeuges, an dem sie angeordnet wird. Die Folie 2 muss nicht planparallel ausgestaltet sein, sondern kann auch die Konturen des Bauteils aufweisen. So ist eine Anbringung der Folie 2 z.B. unterhalb von Kofferraumdeckeln, die aus einem elektrisch nicht leitfähigem Material bestehen, denkbar, genauso wie die Anbringung der Folie 2 auf Fahrzeugscheiben (dann muss die Folie 2 durchsichtig sein) oder sonstigen Bauteilen des Fahrzeuges, wie z.B. Stoßfänger, Schiebedächer, Dachhimmel oder dergleichen.

Die Enden der elektrisch leitfähigen Antennenstrukturen 3 bis 5 sind in einen Kontaktbereich 6 der Folie 2 zusammengeführt, so dass zentral über diesen Kontaktbereich 6 eine Kontaktierung der Antennenstrukturen 3 bis 5 erfolgen kann. Dieser Kontaktbereich 6 steht von den äußeren Konturen der Folie 2 ab, kann aber auch bündig mit den Außenabmessungen der Folie 2 gestaltet sein. Es ist auch nicht zwangsweise erforderlich, dass der Kontaktbereich 6 an einem äußeren Rand der Folie 2 angeordnet ist, sondern kann auch innerhalb der Folie 2 vorhanden sein.

Figur 2 zeigt als Beispiel in vergrößerter Darstellung den Kontaktbereich 6 der Folie 2, wo die Enden der Antennenstrukturen 3 bis 5 zusammengefasst sind. An diesen Enden der Antennenstrukturen 3 bis 5 sind beispielhaft mehrere Kontaktpartner 7, 8, 9 angedeutet, wobei im Regelfall bei mehreren Antennenstrukturen 3 bis 5 jeweils gleiche Kontaktpartner verwendet werden. Der erste Kontaktpartner 7 ist ein Stecker oder eine Buchse, wobei dieser Kontaktpartner mittels eines Crimpvorganges an der Antennenstruktur 3 angeordnet und mit dieser elektrisch kontaktiert wird. Die dargestellte Vercrimpung hat darüber hinaus den Vorteil, dass einerseits der Kontaktpartner 7 an der Folie 2 lagefixiert wird und gleichzeitig die elektrische Kontaktierung mit der Antennenstruktur 3 erfolgt, wobei diese auch eine elektrisch isolierende Deckschicht aufweisen kann, die von dem Crimpvorgang durchstoßen wird. Der zweite Kontaktpartner 8 wird mittels einer Klebeverbindung an der Antennenstruktur 4 kontaktiert, wozu diese freigelegt werden muss, falls sie eine elektrisch isolierende Deckschicht aufweisen sollte. Der weitere Kontaktpartner 9 ist eine Nietverbindung, wobei die beiden Kontaktpartner 8, 9 unlösbar mit ihre zugehörigen Antennenstrukturen 4, 5 verbunden sind. Abgangsseitig sind die Kontaktpartner 8, 9 mit einem elektrischen Leiter 10, insbesondere mittels eines Crimpvorganges, verbunden. Die abgangsseitigen elektrischen Leiter 10 sind beispielsweise Rundleiter (Litzen), wobei sie aber auch als Flachbandkabel ausgebildet sein können. Auf der den Kontaktpartnern 8, 9 abgewandten Seite der elektrischen Leiter 10 sind diese z.B. mit einer Steckverbindung versehen, die mit dem elektronischen Gerät (hier nicht dargestellt) verbunden werden können. Alternativ dazu können die elektrischen Leiter 10 aber auch unlösbar, z.B. mittels eines Lötvorganges, mit dem elektronischen Gerät verbunden sein.

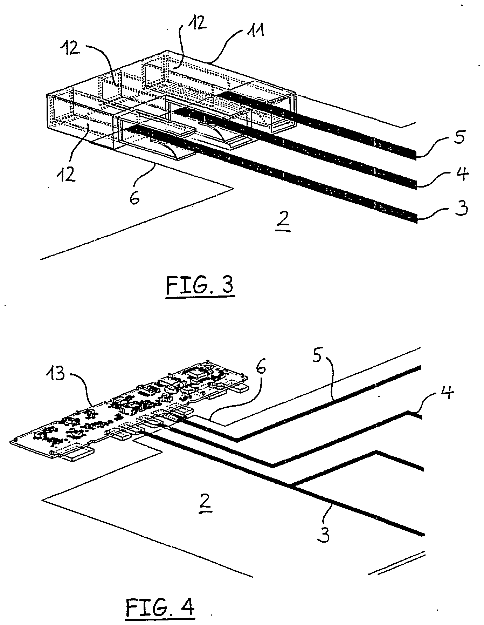

In Figur 3 ist als Beispiel dargestellt, dass im Kontaktbereich 6 der Folie 2 ein Steckverbinder 11 befestigt ist, der mehrere Kontaktpartner 12 aufnimmt, die jeweils mit den Antennenstrukturen 3 bis 5 in geeigneter Weise (z.B. in Schneid-Klemmtechnik, Anlagetechnik oder sonstiger Weise) verbunden sind. Ein solcher Steckverbinder 11 hat den Vorteil, dass er zentral alle Kontaktpartner 12 aufnimmt und diese durch ein elektrisch isolierendes Gehäuse vor Beschädigungen, Kurzschlüssen oder dergleichen schützt. Außerdem ist das Handling eines solchen Steckverbinders 11 wesentlich einfacher als wenn einzelne Kontaktpartner vorhanden sind.

Figur 4 zeigt als Beispiel die Folie 2 mit den darauf angeordneten Antennenstrukturen 3 bis 5, die im Kontaktbereich 6 gebündelt und z.B. über einzelne Steckverbinder mit den korrespondierenden Kontaktstellen (Kontaktpartnern) eines nachgeschalteten elektronischen Gerätes 13 verbunden sind. Bei diesem elektronischen Gerät 13 handelt es sich beispielsweise um einen Antennenverstärker, einen Impedanzwandler, einen Booster, einen Diversity-Prozessor oder dergleichen. Während in Figur 4 jeweils ein Steckverbinder für jeweils eine Antennenstruktur 3 bis 5 dargestellt ist, ist es auch denkbar, den in Figur 3 gezeigten Steckverbinder 11 mit einem entsprechenden Gegensteckverbinder an dem elektronischen Gerät 13 einzustecken.

In Figur 4 ist als Beispiel dargestellt, dass das elektronische Gerät 13 benachbart zu dem Kontaktbereich 6 der Folie 2 angeordnet ist. Während eine Steckverbindung zwischen der Folie 2 und dem elektronischen Gerät 13 gezeigt ist, ist es auch denkbar, die Enden der Antennenstrukturen 3 bis 5 im Kontaktbereich 6 direkt mit korrespondierenden Kontaktstellen des elektronischen Gerätes 13 zu verbinden, insbesondere mittels eines elektrisch leitfähigen Klebers oder eines Lötvorganges. Für den Fall, dass die Folie 2 und das elektronische Gerät 13 nicht benachbart zueinander angeordnet sind, ist es denkbar, im Kontaktbereich 6 sowie im Bereich des elektronischen Gerätes 13 jeweils eine Steckverbindung vorzusehen, und zwischen diesen beiden Steckverbindungen eine elektrisches Kabel (eine Art Verlängerungskabel) mit endseitig angeordneten korrespondierenden Steckverbindungen zwischen zu schalten.

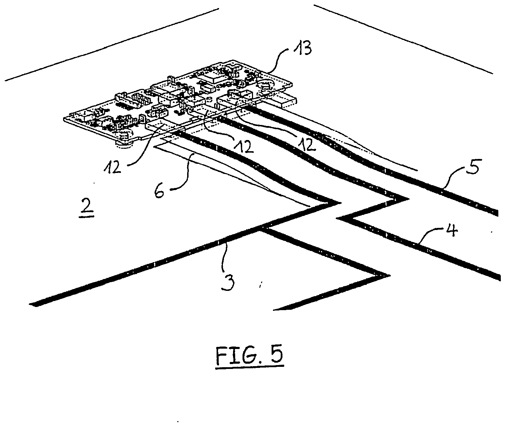

In Figur 5 ist ein Ausführungsbeispiel der Erfindung gezeigt, dass der Kontaktbereich 6 mit den Enden der Antennenstrukturen 3 bis 5 nicht am Rand liegt, sondern innerhalb der Folie 2 angeordnet ist. In diesem Fall kann z.B. nach dem Aufdrucken der Antennenstrukturen 3 bis 5 auf die Folie 2 der Kontaktbereich 6 ausgestanzt werden und mit dem jeweils geeigneten Kontaktpartner verbunden werden. Weiterhin ist auch das elektronische Gerät 13, das seinerseits eine Leiterplatte mit darauf angeordneten Bauteilen aufweist, über Befestigungsmittel (z.B. Nieten) an der Folie 2 befestigt ist. Bei dieser Ausgestaltung sind also innerhalb der Außenabmessungen der Folie 2 sowohl die Antennenstrukturen 3 bis 5 als auch das elektronische Gerät 13 vorhanden und damit ein Modul gebildet, das vorgefertigt, geprüft und dann an den Fahrzeughersteller zum Einbau in das Fahrzeug geliefert werden kann.

Während in Figur 5 gezeigt ist, dass das elektronische Gerät 13 eine Leiterplatte mit elektronischen Bauelementen aufweist und die Antennenstrukturen über Kontaktpartner bzw. Steckverbinder mit dem elektronischen Gerät 13 verbunden sind, ist es in einer weiteren erfindungsgemäßen Ausgestaltung denkbar, dass Leiterbahnen und mit diesen Leiterbahnen kontaktierte (elektronische) Bauelemente zur Realisierung der Funktion des elektronischen Gerätes 13 auf der Folie 2 angeordnet sind. Das bedeutet, dass sowohl die Antennenstrukturen 3 bis 5 als auch die in Figur 5 nicht dargestellten Leiterbahnen, die an und für sich auf der Leiterplatte vorhanden sind, nunmehr allesamt auf die Folie 2 aufgedruckt werden. In diesem Fall entfällt das Ausstanzen des Kontaktbereiches 6 aus der Folie 2. Außerdem entfällt eine elektrische Verbindung (Kontaktierung) der Enden der Antennenstrukturen 3 bis 5 mit den zugehörigen Leiterbahnen des elektronischen Gerätes 13, da diese schon durchgehend auf der Folie 2 vorhanden sind. Dies hat den großen Vorteil, dass damit die gegebenenfalls vorhandenen oder sich einstellenden Kontaktprobleme umgangen werden. Die Leiterbahnen auf der Folie 2 für das elektronische Gerät 13 werden mit den Bauelementen (z.B. SMD-Bauelemente) bestückt, so dass lediglich nur noch eine Steckverbindung für die Stromversorgung des auf der Folie 2 angeordneten elektronischen Gerätes 13 sowie eine ausgangsseitige Steckverbindung zur Abgabe bzw. Einspeisung von Signalen aus bzw. in das elektronische Gerät 13 vorgesehen werden muss. Eine solche Folie 2 mit integriertem elektronischen Gerät kann ebenfalls komplett vorgefertigt, geprüft und dann an den Fahrzeughersteller zum Einbau in das Fahrzeug geliefert werden.

Die erfindungsgemäßen Folien zumindest mit den Antennenstrukturen sind vor allem im Randbereich von Fahrzeugscheiben unter dem Schwarzdruck oder an der Seite eine bevorzugte Lösung. Aber auch eine ganz beklebte Fahrzeugscheibe ist denkbar. Die Folien können auch selbstklebend sein. Die Durchsicht ist dann unproblematisch, da es solche Folienlösungen schon gegen Steinschlag oder Sonneneinstrahlung gibt (allerdings ohne leitende Strukturen und ohne Bauelemente).

In der vorangegangenen Beschreibung wurde der Kontaktbereich 6, genauer die dort endenden Antennenstrukturen 3 bis 5 fest mit Kontaktpartnern (zum Beispiel die Kontaktpartner 7 bis 9, 12) verbunden. Hier ist es alternativ oder ergänzend auch noch denkbar, dass zumindest einer der Kontaktpartner als Federelement ausgebildet ist, welches aus einem elektrisch leitfähigen Material besteht und die Antennenstruktur mit dem weiteren elektrischen Partner (zum Beispiel dem Antennenverstärker bzw. dessen Leiterbahn oder Kontaktstelle) elektrisch verbindet. Das Federelement hat den Vorteil, dass es nach der Kontaktierung unter Vorspannung steht (da es elastisch verformt wurde) und somit die erforderlichen Kontaktkräfte während seiner gesamten Lebensdauer beibehält. Das Federelemt kann dabei so gestaltet sein, dass es auf der Oberfläche der Antennenstruktur zur Anlage kommte oder gegebenenfalls auch zusätzlich die Folie zwecks Erhöhung der mechanischen Stabilität umgreift.

### Bezugszeichenliste:

- 1.: Antennenanordnung
- 2.: Folie
- 3.: Antennenstruktur
- 4.: Antennenstruktur
- 5.: Antennenstruktur
- 6.: Kontaktbereich
- 7.: Kontaktpartner
- 8.: Kontaktpartner
- 9.: Kontaktpartner
- 10.: elektrischer Leiter
- 11.: Steckverbinder
- 12.: Kontaktpartner
- 13.: elektronisches Gerät

## Patentansprüche

1. Antennenanordnung (1) für ein Fahrzeug, wobei die zumindest eine leitfähige Antennenstruktur (3, 4, 5) aufweisende Antennenanordnung (1) In oder auf einem flächigen Bauteil des Fahrzeuges angeordnet ist und elektrisch mit einem elektronischen Gerät (13) kontaktiert ist, wobei die zumindest eine Antennenstruktur (3. 4, 5) In oder auf einer Folie (2) angeordnet ist, wobei die Folie (2) einen Kontaktbereich (6) aufweist, über den die zumindest eine Antennenstruktur (3, 4, 5) direkt oder über zumindest einen Kontaktpartner (7, 8, 9, 12) mit dem elektronischen Gerät (13) elektrisch verbunden ist und die Folie (2) an dem flächigen Bauteil angeordnet wird, **dadurch gekennzeichnet, dass** der Kontaktbereich (6) mit den Enden der Antennenstrukturen (3 bis 5) innerhalb der Folie (2) angeordnet und ausgestanzt ist und dass das elektronische Gerät (13) über Befestigungsmittel an der Folie (2) befestigt ist

2. Antennenanordnung (1) nach Anspruch 1, **dadurch gekennzeichnet, dass** die zumindest eine leitfähige Antennenstruktur (3, 4, 5) lösbar mit dem zumindest einen Kontaktpartner (7, 8, 9, 12) verbunden ist.

3. Antennenanordnung (1) nach Anspruch 2, **dadurch gekennzeichnet, dass** die lösbare Verbindung eine Schraub- oder Steckverbindung ist.

4. Antennenanordnung (1) nach Anspruch 1, **dadurch gekennzeichnet, dass** die zumindest eine leitfähige Antennenstruktur (3, 4, 5) unlösbar mit dem zumindest einen Kontaktpartner (7, 8, 9, 12) verbunden ist.

5. Antennenanordnung (1) nach Anspruch 4, **dadurch gekennzeichnet, dass** die unlösbare Verbindung eine Crimp-, Löt-, Klebe-, Niet- oder Bondverbindung ist.

6. Antennenanordnung (1) nach einem der vorhergehenden Ansprüche, **dadurch gekennzeichnet, dass** die Kontaktpartner (7, 8, 9, 12) direkt mit korrespondierenden Kontaktpartner des elektronischen Gerätes (13) kontaktierbar sind.

7. Antennenanordnung (1) nach einem der vorhergehenden Ansprüche, **dadurch gekennzeichnet, dass** die Kontaktpartner (7, 8, 9, 12) über zumindest einen elektrischen Leiter (10) mit korrespondierenden Kontaktpartner des elektronischen Gerätes (13) kontaktierbar sind.

8. Antennenanordnung (1) nach einem der vorhergehenden Ansprüche, **dadurch gekennzeichnet, dass** Leiterbahnen und mit diesen Leiterbahnen kontaktierte Bauelemente zur Realisierung der Funktion des elektronischen Gerätes (13) auf der Folie (2) angeordnet sind.

9. Antennenanordnung (1) nach einem der vorhergehenden Ansprüche, **dadurch gekennzeichnet, dass** der elektrische Leiter (10) Bestandteil einer Flachbandleitung ist.

10. Antennenanordnung (1) nach einem der vorhergehenden Ansprüche, **dadurch gekennzeichnet, dass** der zumindest ein Kontaktpartner (7, 8, 9, 12) als Federelement ausgebildet ist.

## Claims

1. Antenna arrangement (1) for a vehicle, wherein the antenna arrangement (1) having at least one conductive antenna structure (3, 4, 5) is arranged in or on a planar component of the vehicle and is placed in electrical contact with an electronic device (13), wherein the at least one antenna structure (3, 4, 5) is arranged in or on a film (2), wherein the film (2) has a contact region (6) via which the at least one antenna structure (3, 4, 5) is electrically connected directly or via at least one contact partner (7, 8, 9, 12) to the electronic device (13), and the film (2) is arranged on the planar component, **characterized in that** the contact region (6) is arranged and is punched out with the ends of the antenna structures (3 to 5) within the film (2), and **in that** the electronic device (13) is attached to the film (2) using attachment means.

2. Antenna arrangement (1) according to Claim 1, **characterized in that** the at least one conductive antenna structure (3, 4, 5) is detachably connected to the at least one contact partner (7, 8, 9, 12).

3. Antenna arrangement (1) according to Claim 2, **characterized in that** the detachable connection is a screwed connection or plug-in connection.

4. Antenna arrangement (1) according to Claim 1, **characterized in that** the at least one conductive antenna structure (3, 4, 5) is non-detachably connected to the at least one contact partner (7, 8, 9, 12).

5. Antenna arrangement (1) according to Claim 4, **characterized in that** the non-detachable connection is a crimped connection, soldered connection, adhesive connection, riveted connection or bonded connection.

6. Antenna arrangement (1) according to one of the preceding claims, **characterized in that** the contact partners (7, 8, 9, 12) can be placed directly in contact with corresponding contact partners of the electronic device (13).

7. Antenna arrangement (1) according to one of the preceding claims, **characterized in that** the contact partners (7, 8, 9, 12) can be placed in contact with corresponding contact partners of the electronic device (13) via at least one electrical conductor (10).

8. Antenna arrangement (1) according to one of the preceding claims, **characterized in that** conductor tracks and components which are placed in contact with these conductor tracks are arranged on the film (2) in order to implement the function of the electronic device (13).

9. Antenna arrangement (1) according to one of the preceding claims, **characterized in that** the electrical conductor (10) is a component of a ribbon conductor.

10. Antenna arrangement (1) according to one of the preceding claims, **characterized in that** the at least one contact partner (7, 8, 9, 12) is embodied as a spring element.

## Revendications

1. Ensemble d'antenne (1) pour véhicule, l'ensemble d'antenne (1) qui présente au moins une structure conductrice d'antenne (3, 4, 5) étant disposé dans ou sur un composant plat du véhicule et étant mis en contact électrique avec un appareil électronique (13), **caractérisé en ce que**
la ou les structures d'antenne (3, 4, 5) sont disposées dans ou sur une feuille (2),
**en ce que** la feuille (2) présente une partie de contact (6) par laquelle la ou les structures d'antenne (3, 4, 5) sont reliées électriquement à l'appareil électronique (13), directement ou par l'intermédiaire d'au moins un partenaire de contact (7, 8, 9, 12),
**en ce que** la feuille (2) est disposée sur le composant plat,
**en ce que** la partie de contact (6) est disposée et estampée dans la feuille (2) avec les extrémités des structures d'antenne (3 à 5) et
**en ce que** l'appareil électronique (13) est fixé sur la feuille (2) par l'intermédiaire de moyens de fixation (12).

2. Ensemble d'antenne (1) selon la revendication 1, **caractérisé en ce que** la ou les structures conductrices d'antenne (3, 4, 5) sont reliées de manière libérable au partenaire ou aux partenaires de contact (7, 8, 9, 12).

3. Ensemble d'antenne (1) selon la revendication 2, **caractérisé en ce que** la liaison libérable est une liaison vissée ou enfichable.

4. Ensemble d'antenne (1) selon la revendication 1, **caractérisé en ce que** la ou les structures conductrices d'antenne (3,4,5) sont reliées de manière non libérable au partenaire ou aux partenaires de contact (7, 8, 9, 12).

5. Ensemble d'antenne (1) selon la revendication 4, **caractérisé en ce que** la liaison non libérable est une liaison sertie, brasée, collée, rivetée ou liée.

6. Ensemble d'antenne (1) selon l'une des revendications précédentes, **caractérisé en ce que** les partenaires de contact (7, 8, 9, 12) sont mis en contact direct avec des partenaires de contact correspondants de l'appareil électronique (13).

7. Ensemble d'antenne (1) selon l'une des revendications précédentes, **caractérisé en ce que** les partenaires de contact (7, 8, 9, 12) sont mis en contact par l'intermédiaire d'au moins un conducteur électrique (10) avec des partenaires de contact correspondants de l'appareil électronique (13).

8. Ensemble d'antenne (1) selon l'une des revendications précédentes, **caractérisé en ce que** les pistes conductrices et des composants mis en contact avec des pistes conductrices sont disposés sur la feuille (2) pour permettre le bon fonctionnement de l'appareil électronique (13).

9. Ensemble d'antenne (1) selon l'une des revendications précédentes, **caractérisé en ce que** les conducteurs électriques (10) font partie d'un conducteur en ruban plat.

10. Ensemble d'antenne (1) selon l'une des revendications précédentes, **caractérisé en ce que** le ou les partenaires de contact (7, 8, 9, 12) sont configurés comme éléments élastiques.
